# EUROPÄISCHE PATENTSCHRIFT

(11) **EP 0 344 763 B1**
(45) Veröffentlichungstag und Bekanntmachung des Hinweises auf die Patenterteilung: **01.09.1993**
(21) Anmeldenummer: 89109883.2
(22) Anmeldetag: 01.06.1989
(51) Int. Cl.: H05K 13/00

(54) **Gurtmagazin für SMD-Manipulatoren**
Tape magazine for SMD-manipulators
Magasin à bande pour manipulateurs de SMD

(30) Priorität: 03.06.1988 DE 8807239 U
(43) Veröffentlichungstag der Anmeldung: 06.12.1989
(73) Patentinhaber: Fritsch, Adalbert, D-92280 Kastl (DE)
(72) Erfinder: Fritsch, Adalbert, D-92280 Kastl (DE)
(74) Vertreter: Tergau, Enno, Dipl.-Ing.

(56) Entgegenhaltungen:
- DE-U- 8 518 982
- US-A- 4 440 355

## Beschreibung

Die Erfindung betrifft ein Gurtmagazin für SMD-Manipulatoren (SMD = Surface Mounted Device) mit von Hand zu betätigendem Gurtvorschub und mit folgenden bekannten Merkmalen:
- das Magazin besteht aus einem langgestreckten schmalen Plattenkörper, dessen Breite in Schmalrichtung der Breite des Magazingurtes entspricht;
- die obere Schmalseite des Plattenkörpers ist von zwei Führungsleisten eingefaßt, deren Oberkanten aufeinanderzugewinkelt sind, die zwischen sich einen nach oben offenen Entnahmespalt für die Bauelemente frei lassen und die mit der darunterliegenden Oberseite des Plattenkörpers eine Führungsbahn für den Magazingurt bilden;
- an der Eintrittsseite des Entnahmespaltes befinden sich Einrichtungen zum Abheben des Abdeckbandes und zum Vorschub des Magazingurtes;
- an der Austrittsseite des Entnahmespaltes geht die Führungsbahn in eine Umlenkbahn über, die in eine Rückführungsbahn für den entleerten Gurt mündet, die sich im unteren Bereich des Plattenkörpers befindet.

Derartige Gurtmagazine sind bekannt (siehe z. B. DE-U-8518982). Sie werden insbesondere an solchen SMD-Manipulatoren eingesetzt, welche für die Ausrüstung von kleinen Serien elektronischer Schaltungen bestimmt sind. Sie können dabei als Ergänzung zu den bekannten Drehtellern dienen, die eine Vielzahl von Fächern für Bauelemente haben, die als Schüttgut angeliefert und im Bedarfsfall den Fächern entnommen werden. Sie können aber auch, falls sie in hinreichender Anzahl vorhanden sind, im Austausch für diese Drehteller als alleinige Zulieferer der Bauteile dienen.

Die vorbekannten Gurtmagazine haben sich grundsätzlich bewährt. Allerdings besteht der Wunsch, ihre Baubreite zu verringern und ihre Bedienbarkeit, insbesondere beim Einlegen des neuen Gurtes, zu vereinfachen.

Der Erfindung liegt die Aufgabe zugrunde, die bekannten Gurtmagazine für SMD-Manipulatoren derart weiterzuentwickeln, daß dieses Ziel erreicht wird und daß ohne Rücksicht auf die jeweilige Lage des Gurtmagazines in einer Reihe gleicher nebeneinander angeordneter Magazine jedes einzelne Magazin individuell leicht bedient werden kann, und zwar sowohl beim normalen Gebrauch (Vorschub; Bauteilentnahme) wie auch besonders beim Einfädeln des zugehörenden Gurtbandes.

Zur Lösung dieser Aufgabe wird gemäß dem Kennzeichen des Anspruches 1 vorgeschlagen, daß die Führungsleisten zu einem hochklappbaren Bauteil zusammengefaßt sind, das mit seinem auf der Austrittsseite des Entnahmespaltes gelegenen Ende am Plattenkörper derart angelenkt ist, daß in hochgeklappter Einführungsstellung dieses Bauteils die Oberseite des Plattenkörpers frei zugänglich ist. Durch diese Maßnahme wird erreicht, daß die gesamte Führungsbahn für den Gurt durch einen einfachen Bedienungshandgriff freigelegt werden kann, so daß der Gurt leicht in das Magazin von oben her eingelegt werden kann. Damit können viele derartiger schmaler Gurtmagazine nebeneinander aufgereiht werden, ohne daß die Einlegbarkeit des Gurtes in jedes einzelne Magazin beeinträchtigt werden würde. Es entfällt darüber hinaus das mühselige Einfädeln des Gurtes in dessen Führungsbahn.

Bei der bevorzugten Ausführungsform gemäß Anspruch 2 besteht das hochklappbare Bauteil aus den beiden Führungsleisten, deren Oberkanten aufeinanderzugewinkelt sind, wobei diese Führungsleisten an ihrem vorderen Ende über eine Brücke miteinander verbunden sind. Die Brücke verleiht den beiden Leisten die erforderliche Stabilität und sie gibt außerdem die Möglichkeit, selbst einen Handgriff zur Betätigung des Leistenbauteiles zu bilden. Damit wird die Bedienungsfreundlichkeit nochmals verbessert.

Des weiteren wird in Anspruch 3 vorgeschlagen, daß die zu dem Bauteil zusammengepaßten Führungsleisten um eine Achse schwenkbar sind, die sich in demjenigen Bereich des Plattenkörpers befindet, der auf der der Führungsbahn abgewandten Seite der Umlenkbahn angeordnet ist. Auf diese Weise kann die Führungsbahn zum Beschicken des Magazins mit einem neuen Band und zum Einfädeln in die Rückführanordnung für das entleerte Band völlig bis hinten geöffnet werden, so daß die gesamte Einrichtung frei zugänglich ist.

Die Ansprüche 4-7 kennzeichnen eine vorteilhafte Ausführungsform des Erfindungsgegenstandes, bei der als Einrichtung zum Abheben des Abdeckbandes und zum Vorschub des Magazingurtes oberhalb der Führungsbahn und vor der die beiden Führungsleisten verbindenden Brücke eine das abgezogene Abdeckband aufwickelnde Rollentrommel angeordnet ist, die auf zwei seitlich am Plattenkörper gegenüberliegenden, zwischen sich eine Durchführungsöffnung für den Magazingurt freilassenden Lagerwangen drehbar gelagert ist. Bei dieser Konstruktion wird das aufgabengemäße Ziel der Erfindung, nämlich die leichte Einlegbarkeit des Magazingurtes, erzielt, wobei die schmale Bauform des Magazines ohne weiteres beibehalten werden kann. Zum Einlegen des Magazingurtes wird lediglich die dessen Breite entsprechende Rollentrommel abgenommen, das Leistenbauteil geöffnet und der neue Gurt eingelegt. Nach dem Schließen des Bauteiles kann der Deckbandanfang vom Gurt abgezogen und an der in die Lagerwangen eingelegte Rollentrommel fixiert werden. Durch die Drehung der Rollentrommel wird gleichzeitig das Abdeckband vom Gurt abgezogen und letzterer im Entnahmespalt weitertransportiert. Dabei genügt es, wenn die Rollentrommelachse in nach oben offenen Einlegeausnehmungen an den Lagerwangen eingelegt ist (Anspruch 5).

Die Ansprüche 6 und 7 kennzeichnen eine vorteilhafte Weiterbildung des Erfindungsgegenstandes, mit der in konstruktiv besonderes einfacher Weise eine Fixierung des Leistenbauteils in seiner Schließstellung erzielt wird. Das Lösen und Wiedereinrasten der angegebenen Rastvorrichtung ist darüber hinaus sehr bedienungsfreundlich.

Gemäß Anspruch 8 ist als Einrichtung zum Abheben des Deckbandes und zum Vorschub des Magazingurtes ein in Vorschubrichtung des Gurtes betrachtet vor dem Leistenbauteil angeordneter, schwenkbarer Vorschubhebel vorgesehen, der mit einem nach unten gerichteten Stift in Vorschublöcher des Gurtes einführbar und in Vorschubrichtung hin- und herschiebbar ist. Auch bei dieser Ausgestaltung wird erreicht, daß die gesamte Führungsbahn für den Gurt freigelegt werden kann, so daß der Gurt leicht in das Magazin eingelegt werden kann. Andererseits kann der Vorschubhebel infolge seiner neuartigen Bauweise schmal gehalten und trotzdem leicht individuell erfaßt und hin- und hergeschoben werden. Dadurch wird der Gurt sicher vorbewegt, wobei sich das Abdeckband, welches derartige Gurte zum Abdecken der Magazinvertiefungen aufweisen, leicht abzieht und von einer beliebigen Vorrichtung aufgerollt werden kann. Die schmale Bauweise der jetzt vorgeschlagenen Gurtmagazine macht es auch möglich, die Vorratsrollen für die Gurte gegeneinander versetzt anzuordnen, so daß auf diese Weise in Breitenrichtung gesehen noch mehr Platz gewonnen wird.

Nach Anspruch 9 ist auf der Brücke des Leistenbauteils ein Zentriersporn für den Vorschubhebel angeordnet, der im Gebrauchsfall dafür sorgt, daß der Vorschubhebel genau in die richtige Lage gelangt, um mit seinem Dorn in die Vorschublöcher des Gurtes einzugreifen. Einzelheiten hierzu gehen aus der nachfolgenden Zeichnungsbeschreibung hervor. Die Anordnung kann auch so getroffen werden (Anspruch 10), daß der Zentriersporn nicht auf der Brücke angeordnet wird, sondern selbst die Brücke bildet. Wesentlich ist nur eine hinreichende Stabilisierung des Bauteiles sowie eine sichere Zentrierung des Vorschubhebels.

Des weiteren wird vorgeschlagen (Anspruch 11), daß der Vorschubhebel im Bereich des Entnahmespaltes in die Vorschublöcher des Gurtes einführbar ist. In diesem Bereich liegt der Gurt ohnehin nach oben frei, so daß sich bei dieser Anordnung die einfachste und kompakteste Bauweise ergibt.

Der Vorschubhebel besteht gemäß Anspruch 12 vorzugsweise aus zwei dünnwandigen Seitenstreben, die am vorderen Ende winklig abgebogen sind. Es ergibt sich dadurch der Vorteil, daß der Vorschubhebel die Einrichtung nicht nennenswert verbreitert, so daß die ganze Einrichtung möglichst schmal gehalten werden kann. Durch die Abwinklung entsteht andererseits eine hinreichende Stabilität, was insbesondere für den dauernd beanspruchten Vorschubhebel wesentlich ist.

Bei einer weiteren vorzugsweisen Ausführungsform (Anspruch 13) umfassen die beiden Seitenstreben des Vorschubhebels den Plattenkörper und sind um eine Drehachse am Ende der Abbiegung schwenkbar gelagert. Die Drehachse selbst durchsetzt einen Spalt (Anspruch 14), der sich in Längsrichtung des Plattenkörpers erstreckt und der in diesem Spalt verschiebbar ist. Als optimal hat es sich erwiesen, wenn die Länge des Spaltes der Länge des Entnahmespaltes entspricht (Anspruch 15).

Schließlich wird in Anspruch 16 vorgeschlagen, daß der Vorschubhebel an seinem einen Ende mit einem Griffteil ausgerüstet ist. Dieses Griffteil kann ein Kunststoffteil sein, welches eine nach oben hochstehende Griffahne aufweist. Das Griffteil kann des weiteren als Traglager für den erwähnten Stift verwendet werden, der zum Vorschieben des Gurtes in dessen Vorschublöcher eingeführt werden muß (Anspruch 17).

Durch die Ausgestaltung des Gurtmagazines gemäß Anspruch 18 wird der Magazingurt im Bereich des Entnahmespaltes durch einen Andruckstempel gegen die Führungsleisten gedrückt. Damit nimmt der Magazingurt in der Führungsbahn immer eine definierte Höhenposition ein, was insbesondere im Zusammenhang mit Bestückungsautomaten für deren störungsfreien Betrieb von Wichtigkeit ist.

Die Erfindung ist im folgenden anhand der beigefügten Zeichnung näher erläutert. Es stellen dar:
- Fig. 1: eine perspektivische Darstellung des Gurtmagazins in einer ersten Ausführungsform im geschlossenen Zustand ohne Magazingurt,
- Fig. 2: einen Vertikalschnitt entlang der Mittelebene des Gurtmagazins gemäß Fig. 1 in geöffnetem Zustand,
- Fig. 3: eine vereinfachte perspektivische Darstellung einer zweiten Ausführungsform des Gurtmagazins im geschlossenen, arbeitsbereiten Zustand und
- Fig. 4: eine Darstellung des Gurtmagazins gemäß Fig. 3 im geöffneten Zustand.

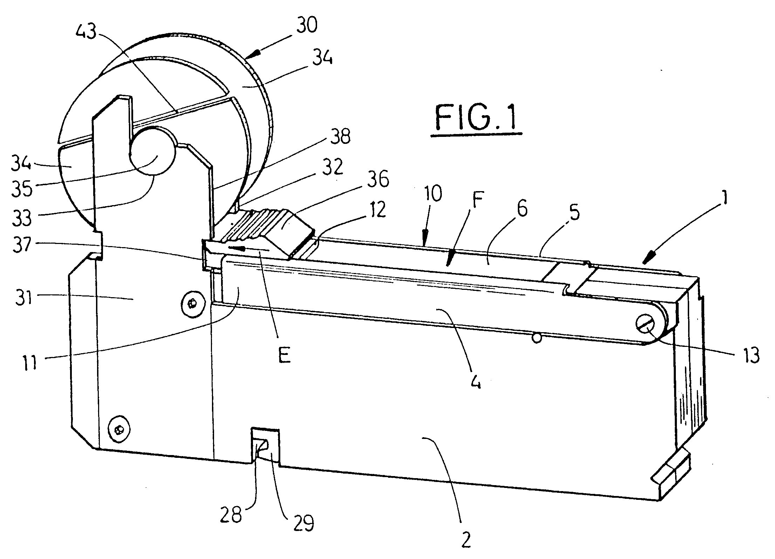

Das Gurtmagazin gemäß Fig. 1,2 bzw. 3,4 ist als Ganzes mit 1 bzw. 1' bezeichnet. Entsprechende Bauteile sind mit gleichen Bezugsziffern versehen. Es besteht aus dem langgestreckten schmalen Plattenkörper 2, dessen Breite im wesentlichen der Breite des Magazingurtes 3 entspricht.

Die obere Schmalseite des Plattenkörpers ist von zwei Führungsleisten 4 und 5 eingefaßt, deren Oberkanten aufeinanderzugewinkelt sind und die zwischen sich einen oben offenen Entnahmespalt 6 für die Bauelemente frei lassen. Diese Bauelemente sind in bekannter Weise in Vertiefungen 7 des Gurtes 3 angeordnet.

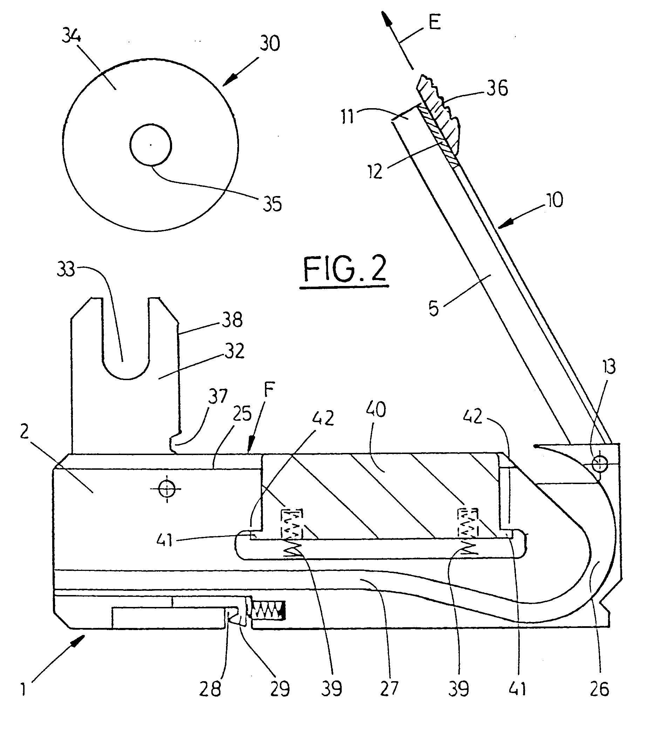

Die Zeichnung läßt erkennen, daß der Gurt 3 im Gebrauchszustand oben in das Magazin eingeführt wird. Der Gurt wird dabei sicher in der von den Führungsleisten 4,5 und der Oberseite 25 des Plattenkörpers 2 gebildeten Führungsbahn F geführt und beim Vorschieben in Richtung des Pfeiles 8 bewegt. Das die Vertiefungen normalerweise verschließende Abdeckband 9 wird beim Vorziehen des Gurtes abgezogen und nach oben aus dem Magazin herausgeführt. Im Entnahmespalt 6 liegt eine hinreichende Anzahl von gefüllten Vertiefungen frei, so daß die Bauteile dort entnommen werden können. Der Gurt wird durch eine in Fig. 2 dargestellte Umlenkeinrichtung im Innern des Plattenkörpers weitergeführt und der entleerte Gurt tritt schließlich bei 3' aus dem Magazin wieder aus. Die Umlenkeinrichtung ist von der sich an die Führungsbahn F anschließenden Umlenkbahn 26 gebildet, die einen etwa halbkreisförmigen Bogen im Inneren des Plattenkörpers 2 beschreibt. Sie setzt sich in einer Rückführungsbahn 27 fort, die den Plattenkörper 2 parallel zur Führungsbahn F durchsetzt und auf der gegenüberliegenden Schmalseite des Plattenkörpers 2 entsprechend der Position 3' aus diesem austritt. Unterhalb der Rückführungsbahn 27 ist im Plattenkörper 2 ein Einschnitt 28 vorgesehen, mit dem das Gurtmagazin 1 unter Mitwirkung der federbeaufschlagten Schnappnase 29 auf eine Halterung fest aufgeschnappt werden kann.

Erfindungsgemäß sind die sonst fest am Plattenkörper befestigten Führungsleisten 4,5 zu einem hochklappbaren Bauteil 10 zusammengefaßt. Dieses Bauteil besteht also aus den beiden genannten Führungsleisten, die an ihrem vorderen Ende 11 über eine Brücke 12 miteinander verbunden sind. Das Bauteil weist am entgegengesetzten Ende (Austrittsseite des Entnahmespaltes 6) eine Achse 13 auf, die sich auf der der Führungsbahn F abgewandten Seite der Umlenkbahn 26 befindet, und um die das Bauteil 10 hochklappbar ist.

In der Ausführungsform gemäß Fig. 1 und 2 ist als Einrichtung zum Abheben des Abdeckbandes 9 und zum Vorschub des Magazingurtes 3 oberhalb der Führungsbahn F und vor der die beiden Führungsleisten 4,5 verbindenden Brücke 12 eine das abgezogene Abdeckband 9 aufwickelnde Rollentrommel 30 vorgesehen. Diese ist auf den zwei seitlich am Plattenkörper 2 gegenüberliegenden, zwischen sich eine Durchführungsöffnung für den Magazingurt 3 freilassenden Lagerwangen 31,32 drehbar gelagert. Dazu weisen die Lagerwangen 31,32 jeweils nach oben offene, halbkreisförmige Einlegeausnehmungen 33 für die als Achsstummel an den seitlichen Trommelscheiben 34 angeformte Trommelachse 35 auf. Die Brücke 12 weist einen handbetätigbaren Rastschieber 36 auf, der mit seinem Rastende in Schließstellung des Bauteils 10 in entsprechenden Rastausnehmungen 37 an den entnahmespaltseitigen Randkanten 38 der Lagerwangen 31,32 eingreift. Der Rastschieber ist in Eingriffsrichtung E federbeaufschlagt (nicht dargestellt).

Wie in Fig. 2 erkennbar ist, ist im Plattenkörper 2 verschiebbar und unter Beaufschlagung durch die beiden Druckfedern 39 ein Andruckstempel 40 gelagert. Der Verschiebeweg ist durch seitliche Vorsprünge 41 am Andruckstempel 40 und entsprechende Anschläge 42 im Plattenkörper 2 auf die Höhe der Führungsbahn F begrenzt. Der Andruckstempel 40 drückt den Magazingurt 3 im Bereich des Entnahmespaltes 6 von der Oberseite des Plattenkörpers 2 ausgehend gegen die Führungsleisten 4,5.

Zur Beschickung des Gurtmagazins 1 mit einem Magazingurt 3 werden die Rollentrommel 30 aus den Lagerwangen 31,32 entnommen,der Rastschieber 36 geöffnet und das Bauteil 10 hochgeklappt (Fig. 2). Somit liegt die gesamte Führungsbahn F frei und es kann von oben der Magazingurt 3 eingelegt werden. Nach dem Schließen des Bauteils 10 mit dem Einrasten des Rastschiebers 36 in die Rastausnehmungen 37 an den Lagerwangen 31,32 wird das Abdeckband 9 abgezogen und im Halteschlitz 43 in einer der beiden Trommelscheiben 34 festgelegt. Nach dem Einlegen der Rollentrommel 30 in die Einlegeausnehmungen 33 der Lagerwangen 31,32 kann der Magazingurt 3 durch eine Drehung der Rollentrommel 30 weitertransportiert werden, was durch den auf das Abdeckband 9 ausgeübten Zug erfolgt. Der Magazingurt 3 fädelt sich dabei selbsttätig in die Umlenkbahn 26 ein.

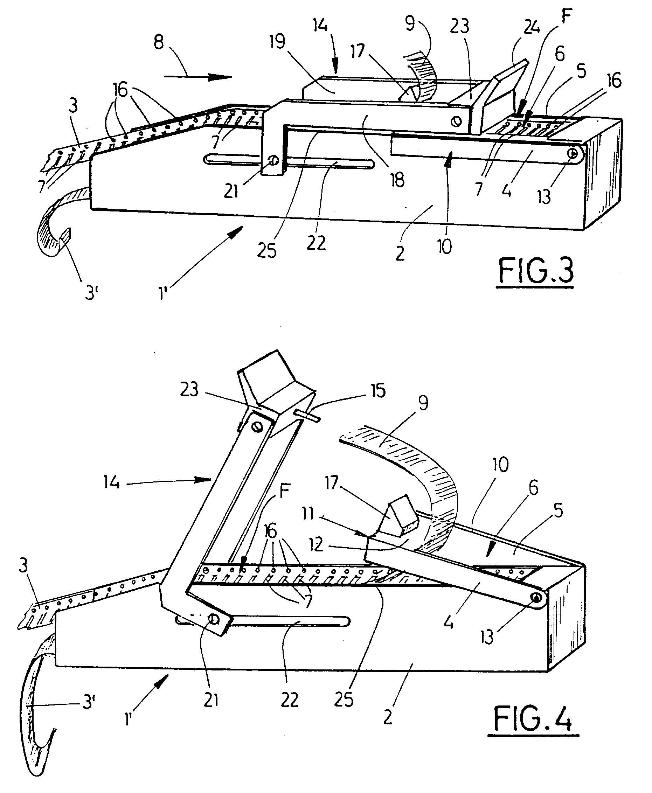

In der alternativen Ausführungsform gemäß den Fig. 3 und 4 ist ein schwenkbarer Vorschubhebel 14 vorhanden, der mit einem nach unten gerichteten Stift 15 in Vorschublöcher 16 des Gurtes 3 einführbar ist und der in Vorschubrichtung (Pfeil 8) hin- und herschiebbar ist.

Sind die in den Vertiefungen 7 im Bereich des Entnahmespaltes 6 vorhandenen Bauteile verbraucht, so kann der Vorschubhebel 14, der sich dann in der in Fig. 1 dargestellten Stellung befindet, leicht vorgeschoben werden, wobei er den Gurt 3 ein entsprechendes Stück mitnimmt. Der Hebel wird dann leicht angehoben, nach hinten zurückgeschoben und wieder aufgesetzt. Im Bereich der Entnahmeöffnung liegen dann wieder gefüllte Vertiefungen des Gurtes.

Bei der geschilderten Funktionsweise der Einrichtung ist es wichtig, daß der Stift 15 beim Absenken des Vorschubhebels 14 immer genau in die Vorschublöcher 16 des Gurtbandes 3 eingreift. Um dies sicherzustellen, befindet sich auf der Brücke 12 ein Zentriersporn 17, der bei abgesenktem Vorschubhebel 14 in den Zwischenraum zwischen den beiden Führungsleisten 4 und 5 eingreift und den Hebel selbsttätig in die richtige Lage bringt.

Besonders vorteilhaft ist es, wenn die genannten Teile so in Relation zueinander angeordnet sind, daß der Vorschubhebel 14 im Bereich des Entnahmespaltes 6 in die Vorschublöcher 16 des Gurtes 3 einführbar ist. Dieser Fall ist auch in der Zeichnung wiedergegeben.

Der Vorschubhebel 14 besteht vorzugsweise aus zwei dünnwandigen Seitenstreben 18 und 19, die am vorderen Ende 20 winklig abgebogen sind. Sie erhalten auf diese Weise eine hinreichende Stabilität, ohne daß der Vorschubhebel 14 nennenswert breiter als der Plattenkörper 2 sein muß. Die beiden Seitenstreben 18,19 umfassen dabei den Plattenkörper 2 und sie sind um eine Drehachse 21 am Ende der Abbiegung schwenkbar gelagert. Diese Drehachse 21 durchsetzt einen Spalt 22, der sich in Längsrichtung des Plattenkörpers 2 erstreckt und sie ist in diesem Spalt verschiebbar. Vorzugsweise entspricht die Länge des Spaltes 22 der Länge des Entnahmespaltes 6.

Der Vorschubhebel 14 ist im dargestellten bevorzugten Ausführungsbeispiel an seinem einen Ende mit einem Griffteil 23 ausgerüstet. Dieses Griffteil ist mit einem Griff 24 bestückt, über den der Vorschubhebel 14 leicht bewegt werden kann. Bei einer bevorzugten Ausführungsform dient das Griffteil 23 zusätzlich als Halterung für den bereits erwähnten Stift 15, der zum Transport des Gurtes 3 in die Vorschublöcher 16 eingeführt wird.

Das Innere des Gurtmagazins 1' entspricht im wesentlichen dem des Gurtmagazins 1, was insbesondere für die Umlenk- 26 und Rückführungsbahn 27 zutrifft.

## Patentansprüche

1. Gurtmagazin für SMD-Manipulatoren mit von Hand zu betätigendem Vorschub, wobei:
- das Magazin aus einem langgestreckten schmalen Plattenkörper (2) besteht, dessen Breite in Schmalrichtung der Breite des Magazingurtes (3) entspricht; wobei
- die obere Schmalseite (25) des Plattenkörpers (2) von zwei Führungsleisten (4,5) eingefaßt ist,
-- deren Oberkanten aufeinanderzugewinkelt sind; wobei
-- die Führungsleisten zwischen sich einen nach oben offenen Entnahmespalt (6) für die Bauelemente frei lassen und
-- mit der darunterliegenden Oberseite (25) des Plattenkörpers (2) eine Führungsbahn (F) für den Magazingurt (3) bilden; wobei
- an der Eintrittsseite des Entnahmespaltes (6) sich Einrichtungen zum Abheben des Abdeckbandes (9) und zum Vorschub des Magazingurtes (3) befinden;
- und wobei an der Austrittseite des Entnahmespaltes (6) die Führungsbahn (F) in eine Umlenkbahn (26) übergeht, die in eine Rückführungsbahn für den entleerten Gurt (3) mündet, die sich im unteren Bereich des Plattenkörpers (2) befindet,
dadurch gekennzeichnet,
daß die Führungsleisten (4,5) zu einem hochklappbaren Bauteil (10) zusammengefaßt sind, das mit seinem auf der Austrittsseite des Entnahmespaltes (6) gelegenen Ende am Plattenkörper (2) derart angelenkt ist, daß in hochgeklappter Einführungsstellung dieses Bauteils (10) die Oberseite (25) des Plattenkörpers (2) frei zugänglich ist.

2. Gurtmagazin nach Anspruch 1,
dadurch gekennzeichnet,
daß die beiden Führungsleisten (4,5) des Bauteils (10) an ihren Freienden (11) über eine Brücke (12) miteinander verbunden sind.

3. Gurtmagazin nach Anspruch 1 oder 2,
dadurch gekennzeichnet,
daß das Bauteil (10) um eine Achse (13) schwenkbar am Plattenkörper (2) angelenkt ist, die auf der der Führungsbahn (F) abgewandten Seite der Umlenkbahn (26) angeordnet ist.

4. Gurtmagazin nach einem der Ansprüche 1 bis 3,
dadurch gekennzeichnet,
daß als Einrichtung zum Abheben des Abdeckbandes (9) und zum Vorschub des Magazingurtes (3) oberhalb der Führungsbahn (F) und vor der die beiden Führungsleisten (4,5) verbindenden Brücke (12) eine das abgezogene Abdeckband (9) aufwickelnde Rollentrommel (30) angeordnet ist, die auf zwei seitlich, am Plattenkörper (2) gegenüberliegenden zwischen sich eine Durchführungsöffnung für den Magazingurt (3) freilassenden Lagerwangen (31,32) drehbar gelagert ist.

5. Gurtmagazin nach Anspruch 4,
dadurch gekennzeichnet,
daß die Lagerwangen (31,32) jeweils nach oben offene Einlegeausnehmungen (33) für die Trommelachse (35) aufweisen.

6. Gurtmagazin nach Anspruch 4 oder 5,
dadurch gekennzeichnet,
daß die Brücke (12) einen handbetätigbaren Rastschieber 36) aufweist, der mit seinem Rastende in Schließstellung des Bauteils (10) in entsprechende Rastausnehmungen (37) an den entnahmespaltseitigen Randkanten (38) der Lagerwangen (31,32) eingreift.

7. Gurtmagazin nach Anspruch 5,
dadurch gekennzeichnet,
daß der Rastschieber (36) in Eingriffsrichtung (E) federbeaufschlagt ist.

8. Gurtmagazin nach einem der Ansprüche 1 bis 3,
dadurch gekennzeichnet,
daß als Einrichtung zum Abheben des Deckbandes (9) und zum Vorschub des Magazingurtes (3) in Vorschubrichtung (8) des Gurtes (3) betrachet vor dem Bauteil (10) ein schwenkbarer Vorschubhebel (14) angeordnet ist, der mit einem nach unten gerichteten Stift (15) in Vorschublöcher (16) des Gurtes (3) einführbar und in Vorschubrichtung (8) hin- und herschiebbar ist.

9. Gurtmagazin nach Anspruch 8,
dadurch gekennzeichnet,
daß auf der Brücke (12) zwischen den Führungsleisten (4,5) ein Zentriersporn (17) für den Vorschubhebel (14) angeordnet ist.

10. Gurtmagazin nach Anspruch 8,
dadurch gekennzeichnet,
daß am vorderen Ende (1) der Führungsleisten (4,5) ein Zentriersporn (17) für den Vorschubhebel (14) angeordnet ist, welcher die Führungsleisten (4,5) als Brücke (12) miteinander verbindet.

11. Gurtmagazin nach einem der Ansprüche 8 bis 10,
dadurch gekennzeichnet,
daß der Vorschubhebel (14) im Bereich des Entnahmespaltes (6) in die Vorschublöcher (16) des Gurtes (3) einführbar ist.

12. Gurtmagazin nach einem der Ansprüche 8 bis 11,
dadurch gekennzeichnet,
daß der Vorschubhebel (14) aus zwei dünnwandigen Seitenstreben (18,19) besteht, die am vorderen Ende (20) winklig abgebogen sind.

13. Gurtmagazin nach Anspruch 12,
dadurch gekennzeichnet,
daß die beiden Seitenstreben (18,19) des Vorschubhebels (14) den Plattenkörper (2) umfassen und um eine Drehachse (21) am Ende der Abbiegung schwenkbar gelagert sind.

14. Gurtmagazin nach Anspruch 13,
dadurch gekennzeichnet,
daß die Drehachse (21) einen Spalt (22) durchsetzt und in diesem Spalt (22) verschiebbar ist.

15. Gurtmagazin nach Anspruch 14,
dadurch gekennzeichnet,
daß die Länge des Spaltes (22) der Länge des Entnahmespaltes (6) entspricht.

16. Gurtmagazin nach einem der Ansprüche 8 bis 15,
dadurch gekennzeichnet,
daß der Vorschubhebel (14) an seinem Freiende mit einem Griffteil (23) ausgerüstet ist.

17. Gurtmagazin nach Anspruch 16,
dadurch gekennzeichnet,
daß an der Unterseite des Griffteiles (23) der Stift (15) angeordnet ist, der in die Vorschublöcher (16) des Gurtes (3) einführbar ist.

18. Gurtmagazin nach einem der vorgenannten Ansprüche,
dadurch gekennzeichnet,
daß im Plattenkörper (2) verschiebbar und unter Federbeaufschlagung (Druckfeder 39) ein Andruckstempel (40) gelagert ist, der den Magazingurt (3) im Bereich des Entnahmespaltes (6) von der Oberseite (25) des Plattenkörpers (2) gegen die Führungsleisten (4,5) drückt.

## Claims

1. A tape magazine for SMD manipulators for manually advancing a tape, in which
- the magazine consists of an elongated, narrow plate body (2) whose width in the small direction corresponds to the width of the magazine tape (3); and in which
- two guide bars (4, 5) are disposed adjacent to the upper narrow face (25) of said plate body (2),
-- whose upper edges are bent towards each other;
-- said guide bars defining an upwardly open removal gap (6) for the removal of the components from the tape, and
-- forming together with said upper face (25) of the plate body (2), situated underneath, a guide path (F) for the magazine tape (3); and in which
- means are disposed on the entrance side of the removal gap (6) for lifting off the covering tape (9) and for advancing the magazine tape (3); and in which
- said guide path (F), on the exit side of said removal gap (6) changes into a reversal path (26) changing in its turn into a return path for the emptied tape (3), arranged in the lower area of the plate body (2),
wherein
the guide bars (4, 5) are combined in an upward folding element (10) whose end situated on the exit side of the removal gap (6) is attached to the plate body (2) in such a way that in folded-up insertion position of said element (10) the upper face (25) of the plate body (2) is freely accessible.

2. A tape magazine according to claim 1,
wherein
the free ends (11) of the two guide bars (4, 5) of the element (10) are connected with each other by means of a bridge (12).

3. A tape magazine according to claims 1 or 2,
wherein
the element (10) is attached to said plate body (2) so as to be pivotal about an axis (13) disposed on the side of the reversal path (26) facing away from the guide path (F).

4. A tape magazine according to any of claims 1 to 3,
wherein
said means for lifting off the covering tape (9) and for advancing the magazine tape (3), disposed above the guide path (F) and in front of the bridge (12) connecting the two guide bars (4,5), consists of a reel (30) for winding up the lifted-off covering tape (9), which is rotatably mounted on two bearing cheeks (31, 32) attached to the sides of the plate body (2) and facing each other so as to define a passage opening for the magazine tape (3).

5. A tape magazine according to claim 4,
wherein
each of said bearing cheeks (31, 32) has an upwardly open insertion recess (33) for the reel shaft (35).

6. A tape magazine according to claims 4 or 5,
wherein
said bridge (12) includes a manually operable sliding detent member (36) whose detent end engages into corresponding detent recesses (37) disposed in the marginal edges (38) - on the side of the removal gap - of the bearing cheeks (31, 32), when said element is in its closed position.

7. A tape magazine according to claim 5,
wherein
said sliding detent member (36) is resiliently biased in engaging direction (E).

8. A tape magazine according to any of claims 1 to 3,
wherein
said means for lifting off the covering tape (9) and for advancing the magazine tape (3) is a pivotable advancing lever (14) which is arranged upstream of said element (10), as viewed in the direction of advancement (8) of the tape (3), and which has a downward pointing pin (15) for insertion into feed holes (16) of the tape (3) and which can be moved back and forth parallel to the direction of advancement (8).

9. A tape magazine according to claim 8,
wherein
a centering spur (17) for centering said advancing lever (14) is arranged on the bridge (12) and between the guide bars (4, 5).

10. A tape magazine according to claim 8,
wherein
a centering spur (17) for centering said advancing lever (14) is arranged at the front end (1) of the guide bars (4, 5), which connects the guide bars (4, 5) with each other in the form of a bridge (12).

11. A tape magazine according to any of claims 8 to 10,
wherein
the advancing lever (14) can be inserted, in the area of the removal gap (6), into the feed holes (16) of the tape (3).

12. A tape magazine according to any of claims 8 to 11,
wherein
the advancing lever (14) consists of two thin-walled lateral struts (18, 19) having angled bent portions at their front ends (20).

13. A tape magazine according to claim 12,
wherein
said two lateral struts (18, 19) of the advancing lever (14) extend around the plate body (2) and are mounted so as to be pivotable about an axis of rotation (21) at the ends of said bent portions.

14. A tape magazine according to claim 13,
wherein
said axis of rotation (21) extends through a slot (22) and is displaceable within said slot (22).

15. A tape magazine according to claim 14,
wherein
the length of said slot (22) is equal to the length of the removal gap (6).

16. A tape magazine according to any of claims 8 to 15,
wherein
the free end of the advancing lever (14) is provided with a gripping member (23).

17. A tape magazine according to claim 16,
wherein
the pin (15), which can be inserted into the feed holes (16) of the tape (3), is disposed on the underside of the gripping member (23).

18. A tape magazine according to any of the previous claims,
wherein
a resiliently biased (pressure spring 39) pressure stamp (40) is displaceably mounted in the plate body (2) for urging the magazine tape (3) in the area of the removal gap (6) from the upper face (25) of the plate body (2) against the guide bars (4, 5).

## Revendications

1. Magasin de bande pour manipulateur SMD avec avance à actionner à la main, dans lequel
- le magasin est composé d'un corps (2) en forme de plaque, étroit, allongé, dont la largeur, dans la direction étroite, correspond à la largeur de la bande (3) du magasin ; dans lequel
- le côté étroit supérieur (25) du corps (2) en forme de plaque est encadré de deux réglettes de guidage (4, 5),
-- dont les bords supérieurs sont rabattus l'un vers l'autre ; dans lequel
-- les réglettes de guidage laissent libre entre elles une fente de prélèvement (6) ouverte vers le haut, pour les composants, et
-- forment avec la face supérieure sous-jacente (25) du corps (2) en forme de plaque une voie de guidage (7) pour la bande (3) du magasin ; dans lequel
- sur le côté d'entrée de la fente de prélèvement (6), se trouvent des dispositifs pour soulever la bande de recouvrement (9) et pour faire avancer la bande (3) du magasin ;
- et dans lequel, sur le côté de sortie de la fente de prélèvement (6), la voie de guidage (F) se termine en une voie de renvoi (26) qui débouche dans une voie de retour de la bande (3) dégarnie qui se trouve dans la région inférieure du corps (2) en forme de plaque,
caractérisé
en ce que les réglettes de guidage (4, 5) sont réunies pour former un élément (10) relevable qui est articulé sur le corps (2) en forme de plaque, par son extrémité située sur le côté de sortie de la fente de prélèvement (6), de telle manière que, dans la position relevée, ou de chargement, de cet élément (10), le côté supérieur (25) du corps (2) en forme de plaque soit librement accessible.

2. Magasin de bande selon la revendication 1,
caractérisé
en ce que les deux réglettes de guidage (4, 5) de l'élément (10) sont réunies l'une à l'autre à leurs extrémités libres (11) par une traverse (12).

3. Magasin de bande selon la revendication 1 ou 2,
caractérisé
en ce que l'élément (10) est articulé sur le corps (2) en forme de plaque, de manière à pouvoir pivoter autour d'un axe (13) qui est disposé sur le côté de la voie de renvoi (26) qui est à l'opposé de la voie de guidage (F).

4. Magasin de bande selon une des revendications 1 à 3,
caractérisé
en ce qu'il comporte, comme dispositif pour soulever la bande de recouvrement (9) et pour faire avancer la bande (3) du magasin, un tambour de rouleau (30) qui enroule la bande de recouvrement (9) détachée, agencé au-dessus de la voie de guidage (F) et devant la traverse (12) reliant les deux réglettes de guidage (4, 5), et qui tourillonne sur deux joues de portée (31, 32) opposées latéralement sur le corps (2) en forme de plaque, qui laissent libre entre elles une ouverture de passage pour la bande (3) du magasin.

5. Magasin de bande selon la revendication 4,
caractérisé
en ce que les joues de portée (31, 32) présentent des encoches réceptrices (33) ouvertes vers le haut pour recevoir l'axe (35) du tambour.

6. Magasin de bande selon la revendication 4 ou 5,
caractérisé
en ce que la traverse (12) présente un poussoir d'arrêt (36) pouvant être manoeuvré à la main, qui, dans la position de fermeture de l'élément (10), s'engage par son extrémité d'arrêt dans des encoches d'arrêt correspondantes (37) prévues sur les arêtes de bord (38) des joues de portée (31, 32) situées du côté de la fente de prélèvement.

7. Magasin de bande selon la revendication 5,
caractérisé
en ce que le poussoir d'arrêt (36) est chargé par ressort dans le sens d'engagement (E).

8. Magasin de bande selon une des revendications 1 à 3,
caractérisé
en ce qu'il comporte, comme dispositif pour soulever la bande de recouvrement (9) et faire avancer la bande (3) du magasin, un levier d'avance pivotant (14) placé en amont de l'élément (10), considéré dans le sens d'avance (8) de la bande (3), qui peut être mis en prise avec des trous d'avance (16) de la bande (3) par un doigt (15) dirigé vers le bas, et qu'on peut faire aller et venir dans la direction d'avance (8).

9. Magasin de bande selon la revendication 8,
caractérisé
en ce qu'un ergot de centrage (17) pour le levier d'avance (14) est agencé sur la traverse (12) entre les réglettes de guidage (4, 5).

10. Magasin de bande selon la revendication 8,
caractérisé
en ce qu'à l'extrémité avant (1) des réglettes de guidage (4, 5) est agencé un ergot de centrage (17) pour le levier d'avance (14), qui relie les réglettes de guidage (4, 5) l'une à l'autre en formant une traverse (12).

11. Magasin de bande selon une des revendications 8 à 10,
caractérisé
en ce que le levier d'avance (14) peut être engagé dans les trous d'avance (16) de la bande (3) dans la région de la fente de prélèvement (6).

12. Magasin de bande selon une des revendications 8 à 11,
caractérisé
en ce que le levier d'avance (14) est composé de deux barrettes latérales (18, 19) à paroi mince qui sont rabattues en formant un angle à l'extrémité avant (20).

13. Magasin de bande selon la revendication 12,
caractérisé
en ce que les deux barrettes latérales (18, 19) du levier d'avance (14) encadrent le corps (2) en forme de plaque et sont tourillonnées par l'extrémité de la partie rabattue pour pivoter autour d'un axe de rotation (21).

14. Magasin de bande selon la revendication 13,
caractérisé
en ce que l'axe de rotation (21) traverse une fente (22) et peut se déplacer en translation dans cette fente (22).

15. Magasin de bande selon la revendication 14,
caractérisé
en ce que la longueur de la fente (22) correspond à la longueur de la fente de prélèvement (6).

16. Magasin de bande selon une des revendications 8 à 15,
caractérisé
en ce que levier d'avance (14) est équipé d'une partie poignée (23) à son extrémité libre.

17. Magasin de bande selon la revendication 16,
caractérisé
en ce que le doigt (15) qui peut s'engager dans les trous d'avance (16) de la bande (3) est agencé à la face inférieure de la partie poignée.

18. Magasin de bande selon une des revendications précédentes,
caractérisé
en ce que, dans le corps (2) en forme de plaque est monté mobile en translation et sous une charge élastique (ressort de compression 39) un tampon de pression (40) qui presse la bande (3) de magasin contre les réglettes de guidage (4, 5), dans la région de la fente de prélèvement (6) du côté supérieur (25) du corps (2) en forme de plaque.
